(19) Europäisches Patentamt
European Patent Office
Office européen des brevets

(11) **EP 2 289 171 B1**

(12) **FASCICULE DE BREVET EUROPEEN**

(45) Date de publication et mention de la délivrance du brevet:
**25.04.2018 Bulletin 2018/17**

(21) Numéro de dépôt: **09769446.7**

(22) Date de dépôt: **27.05.2009**

(51) Int Cl.:
***H03M 7/30*** *(2006.01)*

(86) Numéro de dépôt international:
**PCT/FR2009/000616**

(87) Numéro de publication internationale:
**WO 2009/156605 (30.12.2009 Gazette 2009/53)**

(54) **PROCÈDE DE TRAITEMENT DE DONNEES NUMERIQUES**

VERFAHREN ZUR VERARBEITUNG NUMERISCHER DATEN

METHOD FOR PROCESSING NUMERICAL DATA

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **02.06.2008 FR 0803017**

(43) Date de publication de la demande:
**02.03.2011 Bulletin 2011/09**

(73) Titulaires:
• **Centre National de la Recherche Scientifique (C.N.R.S.)**
**75794 Paris Cedex 16 (FR)**
• **Université de Nice Sophia Antipolis**
**06108 Nice Cedex 2 (FR)**

(72) Inventeurs:
• **ANTONINI, Marc**
**F-06200 Nice (FR)**

• **HIDD FONTELES, Leonardo**
**F-06200 Nice (FR)**

(74) Mandataire: **Novagraaf Technologies**
**Bâtiment O2**
**2, rue Sarah Bernhardt**
**CS90017**
**92665 Asnières-sur-Seine Cedex (FR)**

(56) Documents cités:
**WO-A-03/103151**

• **PIERRE LOYER ET AL: "Lattice Codebook Enumeration for Generalized Gaussian Source" IEEE TRANSACTIONS ON INFORMATION THEORY, IEEE, US, vol. 49, no. 2, 1 février 2003 (2003-02-01), XP011074685 ISSN: 0018-9448**

**Description**

La présente invention concerne le domaine du traitement de données numériques en vue d'applications telles que la compression de données numériques, la recherche de données numériques, la comparaison de données numériques ou la décompression de données numériques. L'invention concerne le traitement de données audiovisuelles, et plus généralement tout type de données numériques. Le but visé par l'invention est de réduire les temps de traitement et les besoins de ressources informatiques tant en ce qui concerne la puissance de calcul que les besoins de mémoire.

Les applications concernent notamment mais non exclusivement le traitement d'images nécessitant un très grand nombre de données pour la décrire. Pour réduire la durée de transmission et la taille requise pour le stockage, on réalise une compression de l'information en procédant à une extraction de l'information visuelle qui seule sera codée. Cette information codée doit être localisée de manière optimale en fréquence et dans l'espace pour permettre une restitution optimale en évitant toute redondance néfaste aux performances du codage. Pour cela, il est connu de mettre en oeuvre la technique de transformée par ondelette, dont les coordonnées constituent un réseau vectoriel qui est ensuite soumis à une étape de quantification vectorielle.

Le principe de la quantification vectorielle (QV) est de coder une séquence d'échantillons formant un vecteur au lieu de coder chacun des échantillons individuellement. Le codage s'effectue en approximant la séquence à coder par un vecteur appartenant à un catalogue de formes usuellement appelé «codebook». Chacun des vecteurs du catalogue de formes est indexé. Lors du codage, c'est l'index du vecteur le plus proche de la séquence d'échantillons à coder, qui servira à la représenter.

Les solutions connues nécessitent la détermination de chacun des vecteurs, leur enregistrement dans une mémoire et l'exécution ensuite de traitements sur l'ensemble des vecteurs pour les dénombrer. La base de vecteurs peut nécessiter plusieurs gigaoctets, et les temps de calcul pour une base aussi importante sont importants. Le but de l'invention est de proposer un procédé de dénombrement et d'indexage évitant ces inconvénients.

<u>État de la technique</u>

On connaît par l'article [1] un procédé de quantification.

Un réseau (lattice) est un ensemble de vecteurs d'un espace de dimension n formant un groupe additif, au sens mathématique du terme. Le livre [2] décrit en détail de tels réseaux.

On connaît dans l'état de la technique la demande de brevet international WO9933185 concernant un procédé de codage consistant à déterminer un vecteur, dit vecteur (leader en anglais), qui comporte les mêmes composantes que le vecteur quantifié mais dans un ordre prédéterminé, puis à déterminer le niveau d'ordre ou rang dudit vecteur quantifié dans ledit ensemble formé des vecteurs qui ont les mêmes composantes que le vecteur (leader en anglais) et qui sont, dans ledit ensemble, ordonnés de manière prédéterminée. Le procédé consiste ensuite à former un code à partir, d'une part, d'un indice représentatif dudit vecteur (leader en anglais) ainsi déterminé et, d'autre part, dudit rang. On connait aussi l'article "Lattice Codebook Enumeration for Generalised Gaussian Source" (P. Loyer et al., IEEE Transactions on Information Theory. vol 49, no. 2, 2003) dans l'état de la technique qui divulgue un procédé de quantification pour des sources de type gaussienne. La difficulté principale rencontrée pour la conception d'un quantificateur vectoriel algébrique pour la compression est liée au problème de dénombrement et d'indexage des vecteurs dans le réseau régulier de points (qui constitue le dictionnaire de quantification). Nous présentons ici les solutions que nous avons proposées pour résoudre ces problèmes dans le cas d'une source de distribution Gaussienne généralisée (comme par exemple les coefficients d'ondelettes).

La quantification vectorielle algébrique

La quantification a été étudiée depuis quelques dizaines d'années maintenant et les travaux effectués ont développé de nombreux résultats aujourd'hui classiques sur la théorie débit-distorsion. En particulier, il a été montré que la Quantification Vectorielle (QV) possède de nombreux avantages par rapport à la Quantification Scalaire (QS) lorsqu'un codage à longueur fixe est imposé. De plus, les travaux de Shannon ont montré que les performances de la QV sont proches des performances théoriques optimales si la dimension n des vecteurs de quantification est suffisamment grande.

Cependant, il est important de noter que la QV peut se rapprocher de ces performances optimales au prix d'une complexité calculatoire élevée ; complexité qui augmente de façon exponentielle avec la dimension des vecteurs. Généralement, la QV est effectuée en utilisant un dictionnaire non structuré construit à partir de données statistiques représentatives de la source (séquence d'apprentissage). Dans ce cas, la complexité ainsi que les besoins en stockage dus à la taille du dictionnaire peuvent devenir prohibitifs pour des applications de compression. De plus, il existe un problème de robustesse du dictionnaire qui, optimisé pour une séquence d'apprentissage donnée, donne des performances mauvaises pour une image en dehors de la séquence d'apprentissage. Une solution pour surmonter ces problèmes est d'utiliser un QV structuré n-dimensionnel tel que la Quantification Vectorielle Algébrique (QVA) ou encore quantification vectorielle sur réseaux réguliers de points. Comme les vecteurs du dictionnaire sont contraints à appartenir à un réseau régulier structuré, les performances de la QVA sont en général inférieures à celle de la QV non-structurée.

Mais, dans la plupart des applications, ce léger désavantage est compensé par le fait que pour la QVA aucun dictionnaire n'a besoin d'être généré ou stocké, et que la complexité de codage est réduite.

La quantification par réseaux réguliers de points peut être vue comme une généralisation de la quantification scalaire uniforme. Comme dans le cas de la QV non structurée, le terme QVA sera utilisé dans le reste du document soit pour désigner la quantification vectorielle, soit pour désigner un quantificateur vectoriel. La QVA prend en compte les dépendances spatiales entre les coefficients des vecteurs ainsi que les gains de partitionnement et de forme. Quelle que soit la distribution de la source, la QVA est toujours plus efficace que la QS.

Un réseau régulier de points dans $R^n$ est composé par toutes les combinaisons possibles d'un ensemble de vecteurs linéairement indépendants $a_i$ qui constitue la base du réseau $\{y|y = u_1a_1 + u_2a_2 +... + u_na_n\}$ où les coefficients $u_i$ sont des entiers. La partition de l'espace est alors régulière et ne dépend seulement que des vecteurs de base choisis. Chaque base définit un réseau régulier de points différent. La QVA offre la possibilité de réduire considérablement les coûts calcul et stockage par rapport à un QV conçu au moyen d'algorithmes basés sur l'algorithme de Lloyd généralisé. En effet, utiliser les vecteurs d'un réseau régulier comme valeurs de quantification élimine l'opération de construction d'un dictionnaire : le dictionnaire est construit implicitement de par la structure du réseau choisi. L'article [1] décrit des algorithmes rapides de quantification qui utilisent simplement des opérations d'arrondis et qui ne dépendent que de la dimension n des vecteurs. En 1979, Gersho a émis la conjecture que dans le cas asymptotique (c'est-à-dire pour des forts débits), les performances débit-distorsion d'un QVA sont approximativement optimales. Toutefois, bien que la QVA ne soit pas mathématiquement optimale pour des faibles débits, la réduction de complexité apportée par de tels quantificateurs permet d'utiliser de grandes dimensions de vecteurs, ce qui entraîne de meilleures performances expérimentales à débit donné. De bonnes performances débit-distorsion peuvent être obtenues en combinant la QVA avec un codeur entropique, ce qui a motivé quelques travaux sur la QVA dans le domaine des ondelettes. Beaucoup de travaux théoriques sur la QV ont été menés pour des sources Gaussienne et Laplacienne. De plus, dans le cas de sources de type Gaussienne généralisée avec un paramètre de décroissance inférieur à un, il a été montré par que le réseau cubique $Z^n$ était plus performant en termes de débit-distorsion que le réseau $E_8$ et le réseau de Leech. Ce résultat a motivé nos travaux pour combiner la QVA avec la transformée en ondelettes.

Les problématiques traitées par l'invention

Si la quantification par QVA est peu complexe, du fait de la structure géométrique régulière du dictionnaire, sa mise en oeuvre n'est cependant pas immédiate. Dans le cas de modèles non-asymptotiques, le bruit de surcharge est négligé puisque nous supposons l'utilisation d'un codage à longueur variable et d'un dictionnaire infini. Elle soulève en effet un certain nombre de questions concrètes, notamment en termes de calcul et de stockage. Deux problèmes fondamentaux peuvent être mis en avant dans la conception d'un QVA :

a) L'indexage : L'indexage est une opération indépendante de la quantification, elle consiste à assigner à chaque vecteur quantifié, un indice (ou index) qui, une fois codé est transmis sur un canal jusqu'au décodeur. Cette opération est fondamentale dans la chaîne de compression. Elle conditionne en effet le débit binaire et permet le décodage sans ambiguïté des vecteurs. Les méthodes connues sont généralement très peu coûteuses en mémoire, mais présentent une complexité calculatoire non négligeable (algorithmes récursifs), ou fonctionnent seulement dans des cas particuliers (types de réseau ou de troncature particuliers). L'invention concerne une approche plus générale qui permet l'indexage sur des distributions de type Gaussienne généralisée, réalisant un bon compromis coût mémoire/coût calcul.

b) Le dénombrement. Les méthodes d'indexage sont généralement basées sur la connaissance de la population du réseau. Ainsi, nous devons être capable de dénombrer les vecteurs du réseau sur des surfaces (ou à l'intérieur de volumes) n-dimensionnels qui dépendent de la distribution de la source. Une approche classique de dénombrement est basée sur l'utilisation de séries génératrices. Dans ce formalisme, les fonctions Nu ont été introduites. Elles permettent le dénombrement sur des pyramides, c'est-à-dire dans le cas d'une distribution Laplacienne. Nous avons proposé une approche plus générale qui permet le dénombrement sur des distributions de type Gaussienne généralisée, réalisant un bon compromis coût mémoire / coût calcul. Le deuxième brevet propose une solution à cette problématique.

Objet de l'invention

Le but de l'invention est de proposer un procédé de traitement comprenant une étape de quantification vectorielle exécutable avec des ressources informatiques réduites tant en ce qui concerne la mémoire de stockage que le temps de traitement.

La présente invention concerne, à cet effet, selon son acception la plus générale, un procédé de traitement de données numériques comportant une étape de quantification consistant à calculer dans un espace de dimension d au moins un indice vecteur (leader en anglais) $I_l$ pour au moins une partie des vecteurs 1, lesdits vecteurs 1 constituant des descripteurs des données d'entrées, le procédé étant caractérisé en ce que ledit indice vecteur (leader en anglais) $I_l$ correspond au nombre de vecteurs précédents ledit vecteur (leader en anglais) 1 dans l'ordre lexicographique inverse sans étape de détermination de la totalité des vecteurs (leader en anglais)s en anglais).

De préférence, le procédé de traitement ne comporte aucune étape de détermination de vecteur (leader en anglais) autre que le vecteur (leader en anglais) 1 en cours de calcul.

Avantageusement, l'étape de calcul de la norme lp dudit vecteur (leader en anglais) 1 comporte une étape de calcul de la norme à $r_{\delta,d}^{p}$ dudit leader 1 $(x_1, x_2, ..., x_d))$ où $x_l$ à $x_d$ sont ordonnés de manière croissante, $r_{\delta,d}^{p}$ étant égal à la somme des résultats de ladite fonction $T(x_i)$ pour i variant entre 1 et d, la fonction $T(x_i)$ retournant le résultat de la division de la coordonnée $x_i$ élevé à la puissance p par un facteur de précision delta, le résultat de ladite division étant arrondi à l'entier le plus proche.

Selon une variante particulière, ladite étape de calcul de l'indice vecteur (leader en anglais) $I_l$ comporte une étape de calcul de la norme $r^{p}_{delta,d}$ dudit vecteur (leader en anglais) $I(x_1, X_2, ...x_d)$ où $x_1$ à $x_d$ sont ordonnés de manière croissante, et des étapes de dénombrement récursives sur les coordonnées $x_i$ avec i variant entre d et 1, lesdites étapes de dénombrement consistant à dénombrer les vecteurs dont la coordonnée $x_i$ est comprise entre $x_i+1$ et $MIN(x_{i+1}, F(r_{\delta,i}^{p}))$, l'indice $I_l$ étant égal à la somme des résultats des étapes de dénombrement, F(A) étant une fonction qui retourne une valeur entière w dont la valeur T(w) est plus petite ou égale à l'argument A de ladite fonction F.

Selon une autre variante, ladite étape de calcul de l'indice vecteur (leader en anglais) $I_1$ comporte une étape de calcul de la norme $r_{\delta,d}^{p}$ dudit vecteur (leader en anglais) $I(x_1, x_2, ...x_d)$ où $x_1$ à $x_d$ sont ordonnés de manière décroissante, et des étapes de dénombrement récursives sur les coordonnées $x_i$ avec i variant entre 1 et d, lesdites étapes de dénombrement consistant à dénombrer les vecteurs dont la coordonnée $x_i$ est comprise entre $x_i+1$ et $MIN(x_{i-1}, F(r_{\delta,i}^{p}))$, l'indice $I_l$ étant égal à la somme des résultats des étapes de dénombrement, F(A) étant une fonction qui retourne une valeur entière w dont la valeur T(w) est plus petite ou égale à l'argument A de ladite fonction F.

Selon une autre variante, ladite étape de calcul de l'indice vecteur (leader en anglais) $I_l$ comporte une étape de calcul de la norme r dudit vecteur (leader en anglais) $I(x_1, x_2, ...x_d)$ où $x_1$ à $x_d$ sont ordonnés de manière croissante, et des étapes de dénombrement récursives sur les coordonnées $x_i$ avec i variant entre d et 1, lesdites étapes de dénombrement consistant à dénombrer les vecteurs dont la coordonnée $x_i$ est comprise entre $x_i+1$ et $MIN(x_{i+1}, r-x_{i+1})$, l'indice $I_l$ étant égal à la somme des résultats des étapes de dénombrement.

Selon une autre variante, ladite étape de calcul de l'indice vecteur (leader en anglais) $I_l$ comporte une étape de calcul de la norme r dudit vecteur (leader en anglais) $I(x_1, x_2, ...x_d)$ où $x_1$ à $x_d$ sont ordonnés de manière décroissante, et des étapes de dénombrement récursives sur les coordonnées $x_i$ avec i variant entre 1 et d, lesdites étapes de dénombrement consistant à dénombrer les vecteurs dont la coordonnée $x_i$ est comprise entre $x_i+1$ et $MIN(x_{i-1}, r-x_{i-1})$, l'indice $I_l$ étant égal à la somme des résultats des étapes de dénombrement.

L'invention concerne également l'application desdits procédés pour la compression de données vectorielles consistant à enregistrer le résultat du codage binaire dudit index $I_l$ ainsi qu'au moins un indice de signe $I_s$, un indice de norme $I_n$ et un indice de permutation Ip. Lesdites données vectorielles sont :

- des images numériques,

- des séquences vidéo numériques,

- des données audio numériques,

- des objets tridimensionnels numériques,

- des objets tridimensionnels animés numériques,

- des informations enregistrées dans une base de données,

- des coefficients issus de la transformation desdites données vectorielles (exemple : coefficients DCT, coefficients d'ondelettes, ...).

L'invention concerne également l'application desdits procédés pour la recherche dans une base de données vectorielle consistant à calculer pour une information de référence un index $I_{l,ref}$ ainsi qu'au moins un indice de signe $I_{s,ref}$, un indice de norme $I_{n,ref}$ et un indice de permutation $I_{p,ref}$ et à rechercher les données associées aux mêmes indices.

Lesdites données vectorielles sont :

- des images numériques,

- des séquences vidéo numériques,

- des données audio numériques,

- des objets tridimensionnels numériques,

- des objets tridimensionnels animés numériques,

- des objets d'une base de données textuelles.

- des coefficients issus de la transformation desdites données vectorielles (exemple : coefficients DCT, coefficients d'ondelettes, ...).

L'invention concerne également un procédé de reconstruction d'une donnée numérique à partir de l'indice vecteur (leader en anglais) $I_l$ calculé selon un procédé susvisé caractérisé en ce que l'on calcule les coordonnées $(x_1, x_2, ..., x_d)$ d'un vecteur (leader en anglais) $I$ caractérisé en ce que l'on applique à un indice $I_l$ un traitement consistant à rechercher le vecteur (leader en anglais) $I$ dont l'indice $I_l$ correspond au même nombre de vecteurs précédents ledit vecteur (leader en anglais) $I$ dans l'ordre lexicographique inverse sans étape de détermination de la totalité des vecteurs (leader en anglais)s en anglais).

De préférence, on procède à un traitement récursif sur la variable i variant entre d et 1, ledit traitement étant appliqué sur la coordonnée $x_i$ avec $x_i$ variant de $\mathrm{MIN}(\mathbf{x_{i+1}}, \mathrm{F}(r^p_{\delta,i}))$ à 0 et consistant à sommer les résultats des étapes de dénombrement par application de ladite fonction F(A), jusqu'à ce que ladite somme soit supérieure audit indice $I_l$, la coordonnée recherchée $x_i$ étant celle conduisant au dépassement dudit indice $I_l$, le procédé consistant ensuite à poursuivre, pour la coordonnée $x_{i-1}$, la sommation à partir de la valeur $I_l$, où $I_l$, est la valeur précédent la valeur $I_l$ avant ledit dépassement.

Avantageusement, on procède à un traitement récursif sur la variable i variant entre 1 et d, ledit traitement étant appliqué sur la coordonnée $x_i$ avec $x_i$ compris entre $\mathrm{MIN}(\mathbf{x_{i-1}}, \mathrm{F}(r^p_{\delta,i}))$ et 0 et consistant à sommer les résultats des étapes de dénombrement par application de ladite fonction F(A), jusqu'à ce que ladite somme soit supérieure audit indice $I_l$, la coordonnée recherchée $x_i$ étant celle conduisant au dépassement dudit indice $I_l$, le procédé consistant ensuite à poursuivre, pour la coordonnée $x_{i+1}$ la sommation à partir de la valeur $I_l$, où $I_l$, est la valeur précédent la valeur $I_l$ avant ledit dépassement.

Par convention $x_{d+1}$ est l'entier le plus fort permis par la précision du processeur, ou au moins plus élevé que $\mathrm{F}(r^p_{\delta,d})$. Pour la reconstruction, $I_l=0$ pour le traitement de la coordonnée $x_d$ pour le cas croissant, et la coordonnée $x_l$ pour le cas décroissant.

Description détaillée de l'invention

L'invention sera mieux comprise à la lecture d'un exemple non limitatif de réalisation, se référant aux dessins annexés où :

- la figure 1 représente le schéma de principe d'un système de traitement de donnée conforme à l'invention,

- la figure 2 représente un exemple d'enveloppe de $r_{\delta,2}^p = 15$, p = 0,4 et $\delta$ = 0,3 pour un réseau Z$^2$,

- la figure 3 représente la comparaison des besoins de mémoire entre la méthode usuelle et la méthode proposée pour p = 1, $\delta$ = 1 et B = 4,

- l'annexe 1 représente un exemple d'algorithmes de codage et décodage pour la mise en oeuvre de l'invention.

Un système de traitement de données comporte habituellement trois modules principaux. Un premier module (1) reçoit les données d'entrées, par exemple un signal numérique correspondant à une image, et calcule à partir de ce signal échantillonné une transformée en odelette selon des techniques connues.

Le module de quantification (2) réalise un codage des coefficients d'ondelette, par un procédé de quantification et indexation vectoriel des coefficients d'ondelette mettant en oeuvre le procédé selon l'invention.

Le troisième module réalise le codage pour réduire la taille des informations enregistrées ou transmises, par des procédés connus de compression sans pertes.

L'étape de quantification et indexation réalisée par le second module (2) est plus précisément l'objet de l'invention. Cette étape est très gourmande en ressources dans les solutions de l'art antérieur qui impliquent de déterminer l'ensemble des vecteurs vecteur (leader en anglais) et donc de les enregistrer dans une mémoire au moins temporairement.

Un procédé de quantification vectorielle sur réseau est connu et est généralement utilisé dans des systèmes de compression de signaux audio, vidéo et multimédia au sens large. La quantification vectorielle sur réseau est l'extension multidimensionnelle de la quantification scalaire uniforme. Cette dernière consiste à quantifier séparément un signal, par exemple représentatif de chaque pixel d'une image, en 2$^N$ niveaux où N est le nombre de bits alloués au quantificateur. Quant à la quantification vectorielle sur réseau, elle est associée à un réseau régulier et permet de déterminer un vecteur de quantification, ou vecteur quantifié, appartenant au réseau en question dont les composantes sont représentatives des valeurs prises par les signaux à coder.

Plus précisément, l'opération de quantification consiste donc à déterminer, à partir d'un vecteur originel dont chacune des composantes est représentative de la valeur prise par un signal à coder et appartient de ce fait à un ensemble non dénombrable, tel que l'ensemble des nombres réels R, un vecteur quantifié x dont chacune des composantes appartient à un ensemble dénombrable tel que l'ensemble des nombres relatifs Z.

L'indexage de vecteurs de réseau est un problème essentiel dans les applications de quantification de réseau. L'invention concerne une solution à ce problème utilisant les vecteurs vecteurs de réseau et le cadre de la théorie des partitions. Elle fonctionne pour des sources de distribution Gaussienne généralisée et permet l'utilisation de codes produit. Elle permet également d'indexer des vecteurs de dimension élevée.

La quantification vectorielle (QV) pourrait permettre d'obtenir des performances théoriques optimales si la dimension vectorielle est arbitrairement élevée. Malheureusement, la complexité de calcul de QV non structurée optimale telle que LBG augmente de façon exponentielle avec la dimension. De plus, les besoins en stockage peuvent être très importants. Une solution à ce problème de dimensionnalité est l'utilisation de QV contrainte telle que la quantification vectorielle de réseau (LVQ).

L'approche LVQ conduit à la conception d'un dictionnaire structuré dont les vecteurs de code sont régulièrement distribués dans l'espace. Par conséquent, au lieu d'optimiser la position des vecteurs dans l'espace, il est possible d'adapter la source en indexant les vecteurs de réseau conformément à la forme de sa distribution. Pour la plupart des sources de données réelles ceci peut être effectué efficacement en utilisant un code produit, conduisant à un compromis débit-distorsion optimal pour des distributions de sources unimodales symétriques.

En effet, il est possible d'interpréter de telles distributions comme étant un ensemble d'hypersurfaces concentriques ayant la même forme en fonction de la distribution de source. Il est alors possible d'indexer les mots de code de réseau en assignant un premier index (préfixe) correspondant à la norme (rayon) de la surface respective et un second index unique (suffixe) correspondant au dénombrement des vecteurs appartenant à une même surface.

Un grand nombre de sources de données importantes, telles que des coefficients d'image et de parole sous-bande, en particulier ceux obtenus par transformation d'ondelette, peuvent être modélisées par les distributions Gaussiennes généralisées. Cette famille de distributions est paramétrée par un facteur de forme unique p (GG(p)) pour une variable stochastique univariée. Une propriété intéressante des sources ayant des distributions (GG(p)) est que les enveloppes de norme $l_p$ correspondant à des surfaces de probabilité constante. Ceci conduit au développement de codes produit effectifs.

Même si le calcul du préfixe est trivial, le suffixe requiert le dénombrement et l'indexage des vecteurs de réseau situés sur des hypersurfaces données. De plus, l'augmentation de la dimension de l'espace peut rendre l'opération d'indexage très complexe, étant donné que le nombre de vecteurs situés sur une enveloppe augmente fortement avec la norme, comme l'illustre le tableau ci-dessous, représentant la comparaison du nombre de vecteurs d'une hyperpyramide donnée et du nombre total de vecteurs de réseau situés sur cette hyperpyramide (cardinalité) dans le cas d'une norme $l_1$, pour un réseau $Z^n$ et différentes valeurs de dimension et de norme.

| Dimension | Norme | Nombre de vecteurs (leader en anglais)s en anglais) | Cardinalité |
|---|---|---|---|
| 3 | 10 | 13 | 402 |
| | 400 | 884 | 640002 |
| | 1000 | 83834 | 4000002 |
| 9 | 10 | 41 | 1854882 |
| | 172 | $1.37 \cdot 108$ | $9,74 \cdot 10^{15}$ |
| | 1842 | $9,98 \cdot 1015$ | $1,68 \cdot 1024$ |
| 18 | 10 | 42 | 317222212 |
| | 29 | 4426 | $8,42 \cdot 10^{15}$ |
| | 450 | $9,89 \cdot 1015$ | $9,39 \cdot 10^{15}$ |
| 60 | 5 | 7 | 207648024 |
| | 11 | 56 | $1,90 \cdot 10^{15}$ |
| | 303 | $9,88 \cdot 1015$ | $2,54 \cdot 10^{15}$ |
| 120 | 4 | 5 | 138259200 |
| | 9 | 30 | $7,30 \cdot 10^{15}$ |
| | 301 | $9,92 \cdot 1015$ | $9,50 \cdot 10^{34}$ |
| 240 | 3 | 3 | 18432160 |
| | 7 | 15 | $1,17 \cdot 10^{15}$ |
| | 301 | $9,93 \cdot 1015$ | $1,68 \cdot 10^{203}$ |

Dans la littérature, l'indexage du suffixe est généralement effectué selon deux techniques différentes.

La première attribue un index tenant compte du nombre total de vecteurs situés sur une hypersurface donnée (cardinalité). Une autre approche exploite les symétries d'un réseau en utilisant le concept de vecteurs (leader en anglais)s en anglais). Les vecteurs d'une enveloppe de norme $l_p$ correspondent à quelques vecteurs de réseau à partir desquels tous les autres vecteurs de réseau situés sur l'enveloppe correspondante peuvent être obtenus par des permutations et des changements de signe de leurs coordonnées. Ces deux approches ont tendance à présenter des performances débit-distorsion similaires pour des sources isotropes.

Cependant, la plupart des travaux sur l'indexage de réseau proposent des solutions uniquement pour des distributions Laplaciennes ou Gaussiennes, qui sont des cas particuliers de GG(p), avec des paramètres de forme p = 1 et p = 2, respectivement. Quelques auteurs proposent une solution pour le cas particulier p = 0,5. Toutefois, cette méthode de dénombrement ne permet pas la construction de codes produit et la méthode d'indexage dans est très complexe dans la pratique, en particulier pour $p \neq 0,5$, 1 ou 2 avec des dimensions et des normes élevées.

L'invention propose une nouvelle alternative pour l'indexage de vecteurs de réseau $Z^n$ situés sur des enveloppes GG(p) avec $0 < p \leq 2$. La solution proposée est basée sur des vecteurs et utilise la théorie des partitions. L'utilisation de la théorie des partitions nous a permis de surmonter la complexité et les besoins en stockage pour générer et indexer les vecteurs (leader en anglais)s en anglais). Nous proposons un algorithme d'indexage économique qui attribue à la volée l'indexe suffixe sans utiliser des tables de conversion.

Dans la description qui suit, une première partie présente le principe de la LVQ et décrit le problème de l'indexage. Une deuxième partie propose une solution efficace pour indexer des livres de code LVQ de très grande taille, quel que soit le paramètre de forme p, avec un exemple d'indexage. La description précise ensuite le coût en mémoire et en calcul de l'approche proposée et nous indique des valeurs de performances pour un indexage de données réelles effectif.

2. Indexage de vecteurs de réseau

2.1 Définition d'un réseau

Un réseau A dans $R^n$ est composé de toute combinaison intégrale d'un ensemble de vecteurs linéairement indépendants $a_i$ (la base du réseau) telle que :

$$\Lambda = \{x \mid x = u_1a_1 + u_2a_2 + \dots u_na_n\}$$

$$(1)$$

où les $u_i$ sont des entiers. La partition de l'espace est donc régulière et dépend uniquement des vecteurs de base choisis $a_i \in R^m$ ($m \geq n$). Il doit être noté que chaque ensemble de vecteurs de base définit un réseau différent.

Chaque vecteur **v** d'un réseau peut être considéré comme appartenant à une surface ou hypersurface contenant des vecteurs ayant une norme $l_p$ constante donnée par :

$$\|\mathbf{v}\|_p = \left( \sum_{i=1}^{n} |v_i|^p \right)^{\frac{1}{p}}.$$

Il est alors possible de coder un vecteur de réseau donné en utilisant un code produit. Il apparaît clairement que si la distribution des vecteurs sources est Laplacienne un code produit approprié est constitué d'un préfixe correspondant à la norme $l_1$ d'un vecteur et d'un suffixe correspondant à sa position sur l'hyperpyramide avec un rayon égal à la norme $l_1$ en question. Les hypersurfaces de norme $l_1$ constante sont appelées hyperpyramides. La position du vecteur sur une hypersurface peut être obtenue en utilisant un algorithme de dénombrement. Un tel code produit assure l'unicité pour le décodage.

Dans le cas de sources ayant une distribution Gaussienne généralisée avec un paramètre de forme inférieur ou égal à un, la supériorité du réseau $Z^n$ cubique sur $D_4$, $E_8$ ou des réseaux de Leech a été démontrée [12]. Par conséquent, la suite de ce document est focalisée sur la conception d'une LVQ basée sur le réseau $Z^n$ cubique.

2.2 Indexage basé sur un dénombrement total

On connaît dans l'état de la technique plusieurs solutions de dénombrement ont été proposées pour le cas de distributions Gaussiennes ou Laplaciennes et pour différents réseaux basés sur le principe d'un dénombrement total. On connaît notamment, dans le cas d'une distribution de source Laplacienne et pour un réseau $Z^n$, une formule récursive pour calculer le nombre total de vecteurs de réseau situés sur une hyperpyramide de norme $l_1$. Cette formule de dénombrement a été étendue à des distributions de source Gaussiennes généralisées avec un facteur de forme p compris entre 0 et 2. Ces solutions permettent de déterminer le nombre de vecteurs situés à l'intérieur d'une norme de troncature $l_p$ donnée, mais ils ne proposent pas un algorithme pour assigner un index effectif aux vecteurs du réseau $Z^n$. De plus, cette solution ne détermine pas le nombre de vecteurs situés sur une hypersurface donnée, ce qui rend difficile l'utilisation de codes produit.

L'algorithme proposé dans les travaux de l'état de l'art indexe les vecteurs conformément au schéma de code produit pour $0 < p \leq 2$. Il est basé sur les séries thêta généralisées [4] et exploite la géométrie du réseau. Pour p = 1 ou 2, le développement de cette série est relativement simple. Cependant, pour d'autres valeurs de p, le développement de cette série est très complexe, étant donné qu'aucune forme fermée n'est produite et l'utilisation de mathématiques formelles est prohibitive. Avec la solution proposée, il est nécessaire de déterminer chaque valeur de norme possible pour les différentes dimensions et pour des dimensions élevées, ce qui tend à être infaisable dans un temps fini.

De plus, étant donné que la cardinalité d'une hypersurface peut rapidement atteindre des valeurs non tractables pour des mises en oeuvre pratiques, en particulier pour des dimensions élevées (voir Tableau ci-dessus), les techniques d'indexage basées sur la cardinalité de l'enveloppe peuvent rapidement dépasser la précision informatique.

2.3 Indexage à base de vecteurs (leader en anglais)s en anglais)

Les méthodes basées sur des vecteurs tirent profit des symétries du réseau. Elles utilisent un algorithme d'indexage efficace sur les enveloppes de norme constante et n'attribuent pas l'index sur la base du nombre total de vecteurs du réseau, mais sur la base d'un faible nombre de vecteurs appelés vecteurs (leader en anglais)s en anglais). Les différentes symétries du réseau sont traitées séparément ce qui, par rapport aux techniques de dénombrement total, constitue une méthode plus efficace d'indexage de sources lorsque les symétries ne sont pas toutes présentes. De plus, les index gérés par l'algorithme de codage sont beaucoup plus faibles que la cardinalité de l'enveloppe, ce qui permet d'indexer des vecteurs qui ne pourraient pas être indexés par des méthodes basées sur un dénombrement total pour une précision binaire donnée.

Dans l'architecture de code produit, outre les symétries du réseau, l'index suffixe contient l'index d'un faible nombre de vecteurs (vecteurs (leader en anglais)s en anglais)) à partir desquels tous les autres vecteurs de l'hypersurface peuvent être assignés. Pour le réseau $Z^n$, les symétries correspondent à deux opérations basiques : des changements de signe et des permutations des coordonnées vectorielles. La première opération correspond à un changement de l'octant où est situé le vecteur. Par exemple, le vecteur (7, -3) de dimension 2 est dans le quatrième octant, tandis que le vecteur (-7, -3) est dans le troisième. Ces vecteurs sont symétriques par rapport à l'axe y. La seconde opération correspond à la symétrie intra-octant lorsque, par exemple, les vecteurs (-7, 3) et (-3, 7) sont tous deux dans le deuxième octant et symétriques par rapport à la bissectrice de l'octant. Dans ce cas, il peut être observé que tous ces vecteurs peuvent être générés à partir de permutations et de changements de signe du vecteur (3, 7), qui est le vecteur (leader en anglais) de tous ces vecteurs. Avec l'ensemble des permutations et changements de signe, le vecteur (leader en anglais) (3, 7) peut représenter 8 vecteurs. Ce rapport augmente rapidement avec la dimension de l'hypersurface (voir Tableau 1).

Par conséquent, au lieu d'indexer directement tous les vecteurs sur une hypersurface, cette méthode d'indexage assigne à chaque vecteur un ensemble de trois index : l'un correspondant à son vecteur (leader en anglais) et les deux autres correspondant à sa permutation et aux changements de signe du vecteur (leader en anglais). Pour plus de détails sur la méthode de calcul des index de permutation et de signe.

3. Méthode d'indexage proposé

3.1 Indexage de vecteur (leader en anglais) proposé dans le cas de la norme $l_1$

3.1.1 Principe

L'invention propose une solution basée sur la classification de tous les vecteurs dans un ordre lexicographique inverse et attribue un index en fonction du nombre de vecteurs précédant le vecteur (leader en anglais) devant être indexé. Dans le cas présent, l'indexage n'est plus basé sur un algorithme de recherche à forte consommation de ressources ou un adressage direct, mais sur un algorithme de dénombrement à faible coût qui dépend uniquement de la quantité de vecteurs plutôt que de la connaissance explicite de chacun d'entre eux, ce qui permet d'éviter la construction de tables de conversion.

Une hyperpyramide de rayon r est composée de tous les vecteurs $v = (v_1, v_2, ..., v_d)$ de sorte que $\|\mathbf{v}\|_1 = r$. Comme décrit précédemment, les vecteurs sont les vecteurs élémentaires d'une hypersurface à partir desquels des opérations de permutations et de changements de signe conduisent à tous les autres vecteurs situés sur cette hypersurface. En effet, les vecteurs sont des vecteurs ayant des coordonnées positives triées dans l'ordre croissant (ou décroissant). Par conséquent, les vecteurs pour la norme $l_1$ égale à r et la dimension d sont des vecteurs qui satisfont aux conditions ci-dessous :

$$1 - \sum_{i=1}^{d} v_i = r \ ;$$

2 - $0 \leq v_i \leq v_j$, pour $i < j$ et $i, j \in [1, d]$.

3.1.2 Lien avec la théorie des partitions

Dans le cas d'une norme $l_1$, on peut noter que les conditions présentées dans la section 3.1.1 sont liées à la théorie des partitions dans la théorie des nombres. En effet, dans la théorie des nombres, une partition d'un entier positif r est une façon d'écrire r comme étant une somme de d entiers positifs (également appelée part). Le nombre de partitions distinctes (et indépendantes de l'ordre) de r est donné par la fonction de partition P(r) de sorte que :

$$\sum_{r=0}^{\infty} P(r) y^r = \prod_{d=1}^{\infty} \left( \frac{1}{1 - y^d} \right), \tag{2}$$

qui correspond à la réciproque de la fonction d'Euler, également appelée série q [10, 16, 17]. Des développements mathématiques supplémentaires conduisent à des représentations de la fonction P(r) permettant d'accélérer les calculs.

Par exemple, pour r = 5, l'équation (2) donne le résultat P(5) = 7. En effet, toutes les partitions possibles du nombre 5 sont (5), (1, 4), (2, 3), (1, 1, 3), (1, 2, 2), (1, 1, 1, 2) et (1, 1, 1, 1, 1). En réécrivant ces partitions sous forme de vecteurs de dimension 5 tels que (0, 0, 0, 0, 5), (0, 0, 0, 1, 4), (0, 0, 0, 2, 3), (0, 0, 1, 1, 3), (0, 0, 1, 2, 2), (0, 1, 1, 1, 2) et (1, 1, 1, 1, 1), nous observons que ceux-ci correspondent exactement aux vecteurs de l'hyperpyramide de norme r = 5 et de dimension d = 5, c'est-à-dire que ce sont les seuls vecteurs dans l'hyperpyramide de norme r = 5 et de dimension d = 5 qui satisfont aux deux conditions de la section 3.1.1.

Cependant, nous nous intéressons généralement à des enveloppes de norme l1 égale à r dans un réseau d-dimensionnel avec $r \neq d$. Dans ce cas, il est possible d'utiliser la fonction q(r, d) [10, 18] qui calcule le nombre de partitions de r avec au plus d parts (dans la théorie des partitions ceci équivaut à calculer le nombre de partitions de r ne comportant aucun élément supérieur à d avec un nombre quelconque de parts). Par conséquent, pour une hyperpyramide de norme r = 5 et de dimension d = 3, nous avons q(5, 3) = 5, c'est-à-dire, cinq vecteurs donnés par : (0, 0, 5), (0, 1, 4), (0, 2, 3), (1, 1, 3) et (1, 2, 2).

La fonction q(r, d) peut être calculée à partir de la relation de récurrence:

$$q(r, d) = q(r, d - 1) + q(r - d, d)$$

(3)

avec q(r, d) = P(r) pour $d \geq r$, q(1, d) = 1 et q(r, 0) = 0.

3.1.3 Utilisation de la fonction q(r, d) pour indexer les vecteurs (leader en anglais)s en anglais)

Comme décrit ci-après, non seulement l'équation (3) donne le nombre total de vecteurs situés sur une hyperpyramide donnée, mais elle peut également être utilisée pour attribuer à la volée des indices uniques pour les vecteurs (leader en anglais)s en anglais), sans nécessiter des tables de conversion. Afin d'illustrer le principe de l'algorithme proposé, supposons que les vecteurs d'une hyperpyramide donnée sont classés dans l'ordre lexicographique inverse de la façon suivante :

| Valeur d'index | Vecteur (leader en anglais) |
|---|---|
| 0 | $(0,..., 0, 0, r_n)$ |
| 1 | $(0,..., 0, 1, r_n - 1)$ |
| 2 | $(0,..., 0, 2, r_n - 2)$ |
| 3 | $(0,..., 1, 1, r_n - 2)$ |
| . | . |
| . | . |
| . | . |

Ainsi, l'index d'un vecteur (leader en anglais) **l** correspond au nombre de vecteurs qui précèdent celui-ci. Dans l'exemple décrit ci-dessus, le vecteur (leader en anglais) $(0, ..., 1, 1, r_n - 2)$ doit être assigné à l'index 3.

La proposition 1 définit la solution proposée pour l'indexage de vecteur (leader en anglais) :

Proposition 1. Soit **v** = $(v_1, v_2, ..., v_n)$ un vecteur de réseau $Z^n$ avec un vecteur (leader en anglais) $1 = (x_1, x_2, ..., x_n)$ situé sur une enveloppe de norme constante $l_1$. Son index de vecteur (leader en anglais) $I_l$ est donné par :

$$I_l = \sum_{\substack{j=0 \\ \text{tant que } x_{n-(j+1)} \neq 0}}^{n-2} \sum_{i=x_{n-j}+1}^{\min[x_{n-(j-1)}, r_{n-j}]} \overline{q}(r_{n-j} - i, n - (j+1), i)$$

(4)

où $\overline{q}$(r, d, k) calcule le nombre de partitions de r avec au plus d parts inférieures ou égales à k, avec $\overline{q}(0, d, k) = 1$ et $x_{n+1} = +\infty$.

Démonstration. Considérons un vecteur (leader en anglais) $l = (x_1, x_2, ..., x_n)$ de dimension n et de norme $l_1$

$$r_n = \sum_{i=1}^{n} x_i$$ devant être indexé. Étant donné que nous trions les vecteurs dans l'ordre lexicographique inverse, un premier groupe de vecteurs placés avant **I** est composé de tous les vecteurs dont la $n^{\text{ème}}$ composante est strictement supérieure à $x_n$, c'est-à-dire, tous les vecteurs ayant la plus grande coordonnée $g_n$ satisfaisant à $x_n + 1 \leq g_n \leq r_n$.

Afin de compter le nombre de vecteurs de ce premier groupe sans les lister tous, nous utilisons la fonction de partition q(r, d). En effet, le nombre de vecteurs dont la $n^{\text{ème}}$ coordonnée est égale à $g_n$ peut être aisément calculé en utilisant la remarque suivante :

Remarque : le calcul du nombre de vecteurs de norme $r_n$ et de dimension n dont la plus grande coordonnée est égale à $g_n$ revient à calculer le nombre de partitions du nombre $r_n - g_n$ avec au plus n - 1 parts sans aucune part supérieure à $g_n$.

Dans la plupart des cas, nous pouvons compter ce nombre de partitions en appliquant $q(r_n - g_n, n - 1)$. Cependant, cette approche n'est valide que si $r_n - g_n \leq g_n$, auquel cas il est implicitement supposé que toutes les partitions de $r_n - g_n$ n'ont aucune part supérieure à $g_n$. Cependant, dans un cas plus général, dans lequel $r_n - g_n \leq g_n$ n'est pas garanti (par exemple, le nombre de vecteurs de norme $r_n = 20$ et de dimension n = 5 avec la plus grande partie égale à 7 conduirait à q(20-7, 5-1) = q(13, 4), où 20 - 7 $\nleq$ 7), le calcul de $q(r_n - g_n, n - 1)$ conduirait à un nombre erroné de vecteurs valides, étant donné que certaines partitions de $r_n - g_n$ auraient leur plus grande part supérieure à $g_n$, auquel cas la condition 2 dans la section 3.1.1 ne serait pas respectée.

Dans une telle situation, nous devons appliquer une deuxième contrainte au calcul du nombre de partitions : la valeur de la plus grande part. Nous utilisons alors une généralisation de q(r, d), donnée par la fonction $\overline{q}(r, d, k)$, qui calcule le nombre de partitions d'un nombre r donné avec au plus d parts sans aucune part supérieure à k. Le calcul de $\overline{q}(r, d, k)$ est fait à l'aide d'un algorithme de dénombrement.

Par conséquent, nous pouvons calculer le nombre correct de vecteurs valides en appliquant $\overline{q}(r_n - g_n, n - 1, g_n)$. Ainsi, la variation de $g_n$ de $x_n + 1$ à $r_n$ permet de déterminer le nombre de vecteurs dont la plus grande coordonnée est strictement supérieure à $x_n$, donné par :

$$\sum_{i=x_n+1}^{r_n} \overline{q}(r_n - i, n - 1, i)$$

$$(5)$$

où nous supposons que $\overline{q}(0, d, k) = 1$, $\forall d \in z^+$ et $\forall k \in z^*$. Dans ce cas, nous utilisons la notation d'ensemble utilisée dans la théorie des nombres, où $z^+$ représente l'ensemble d'entiers positifs $\{i \in z | i > 0\}$ et $z^*$ l'ensemble d'entiers non négatifs $\{i \in z | i \geq 0\}$.

Un deuxième groupe de vecteurs précédant 1 est composé de tous les vecteurs dont la $n^{\text{ème}}$ coordonnée est égalé à $x_n$ mais avec une $(n - 1)^{\text{ème}}$ coordonnée strictement supérieure à $x_{n-1}$. Afin de compter ce nombre de vecteurs (leader en anglais)s en anglais), nous pouvons utiliser la même remarque précédemment mentionnée, mais cette fois appliquée à la dimension n - 1. Nous pouvons alors calculer le nombre de vecteurs dont la plus grande composante $g_n$ = $x_n$ et la deuxième plus grande composante $g_{n-1} > x_{n-1}$ en utilisant $\overline{q}((r_n - x_n) - g_{n-1}, (n - 1) - 1, g_{n-1})$ ou $\overline{q}(r_{n-1} - g_{n-1}, n - 2, g_{n-1})$, en faisant varier $g_{n-1}$ de $x_{n-1} + 1$ à min($x_n, r_{n-1}$). La fonction min garantit que la norme $r_n$ et l'ordre $g_{n-1} \leq g_n = x_n$ soient respectés.

En étendant le résultat aux dimensions additionnelles, le nombre de vecteurs dont la plus grande coordonnée est égale à $x_n$, mais qui précédent 1 peut être obtenu par :

$$I_l = \sum_{j=1}^{n-2} \sum_{i=x_{n-j}+1}^{\min[x_{n-(j-1)},r_{n-j}]} \overline{q}(r_{n-j} - i, n-(j+1), i)$$

$$\text{tant que } x_{n-(j+1)} \neq 0$$

$$(6)$$

La combinaison des équations (5) et (6) conduit à une formule générale pour calculer le nombre total de vecteurs placés avant 1, et donc l'index $I_l$ de 1 (équation (4)) :

$$I_l = \sum_{j=0}^{n-2} \sum_{i=x_{n-j}+1}^{\min[x_{n-(j-1)},r_{n-j}]} \overline{q}(r_{n-j} - i, n-(j+1), i)$$

$$\text{tant que } x_{n-(j+1)} \neq 0$$

où $x_{n+1} = +\infty$ pour $j = 0$.

3.2 Généralisation au cas d'une norme $l_p$

Afin de calculer l'index du vecteur (leader en anglais) $l = (x_1, x_2, ..., x_n)$ d'un vecteur $\mathbf{v} = (v_1, v_2, ..., v_n)$ situé sur une enveloppe de norme lp constante, avec $0 < p \leq 2$, nous proposons d'appliquer présentement le même principe que dans le cas de $l_1$. Les vecteurs sont listés dans l'ordre lexicographique inverse et nous attribuons l'index en utilisant la même approche de dénombrement. Par conséquent, la structure de l'équation (4) est encore appropriée, où la somme sur i avec la fonction $\overline{q}$ calcule le nombre de vecteurs en fonction d'une coordonnée donnée et la somme sur j permet la récursion sur la dimension.

Cependant, l'utilisation de $\overline{q}$ entraîne implicitement que les termes de somme $x_i^p$ d'une norme r sont des entiers et peuvent être un entier quelconque dans l'intervalle [0, r]. Ceci est évidemment valide pour p = 1, où les termes de somme sont les coordonnées de réseau d'entier positif elles-mêmes. Par contre, pour $p \neq 1$, les termes de somme $x_i^p$ ne sont pas nécessairement des entiers ou ne peuvent pas être un entier quelconque dans l'intervalle [0, r] (par exemple, pour p = 2 les termes de somme sont des entiers, mais uniquement les nombres carrés).

Il est possible de résoudre ce problème en arrondissant $x_i^p$ à l'entier le plus proche avec une précision $\delta$. Une technique similaire a été utilisée dans [7, 9]. Cette opération introduit un nouveau sous-ensemble d'entiers $\mathscr{S}_\delta^p$ composé de tous les entiers $\overline{x}_i$, où $\overline{x}_i = \left[\dfrac{x_i^p}{\delta}\right]$, [·] étant l'entier le plus proche et $x_i \in z^*$.

La norme lp d'un vecteur est alors connue avec une précision $\delta$ et est obtenue par :

$$r_{\delta,n}^p = \sum_{i=1}^{n} \overline{x}_i = \sum_{i=1}^{n} \left[\frac{x_i^p}{\delta}\right]$$

$$(7)$$

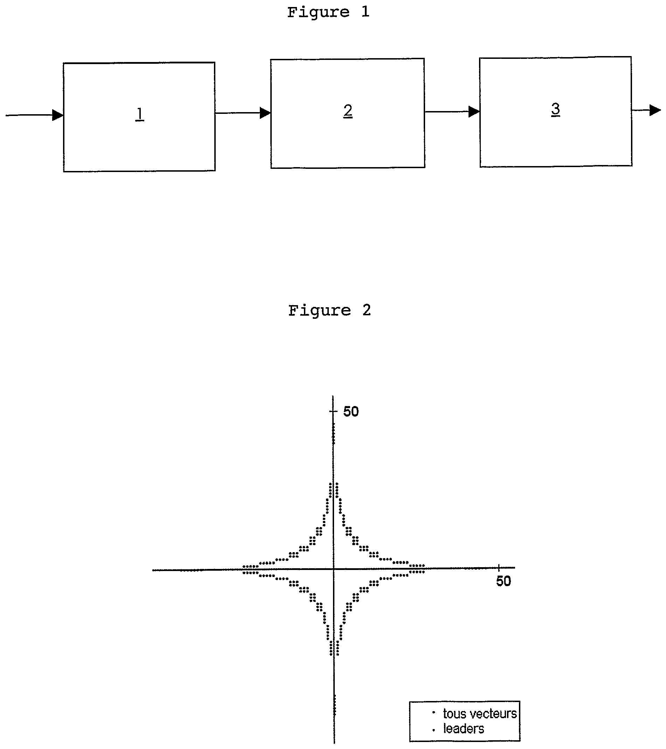

où la précision $\delta$ définit la largeur des enveloppes de norme constante $r_{\delta,n}^p$, comprenant plus de vecteurs au fur et à mesure que sa valeur augmente (voir Figure 2).

Figure 1 : exemple d'enveloppe de $r_{\delta,2}^p = 15$, p = 0,4 et $\delta$ = 0,3 pour un réseau $Z^2$.

En conséquence, le calcul de l'index de vecteur (leader en anglais) d'un vecteur dans une norme lp constante correspond au calcul du nombre correct de partitions d'un nombre entier mais en utilisant uniquement des entiers appartenant au sous-ensemble $\mathcal{S}_\delta^p$. La proposition 2 décrit la solution que nous proposons :

Proposition 2. Soit **v** = ($v_1$, $v_2$, ..., $v_n$) un vecteur de réseau $Z^n$ avec un vecteur (leader en anglais) **l** = ($x_1$, $x_2$, ..., $x_n$) situé sur une enveloppe de norme constante lp. Son index de vecteur (leader en anglais) $I_l$ est donné par :

$$I_l = \sum_{\substack{j=0 \\ \text{tant que } x_{n-(j+1)} \neq 0}}^{n-2} \sum_{i=x_{n-j}+1}^{\min[x_{n-(j-1)}, f(r_{\delta,n-j}^p)]} \overline{q}_\delta^p(r_{\delta,n-j}^p - t(i), n-(j+1), i)$$

$$+ \min(f(\overline{x}_1), x_2) - x_1$$

$$(8)$$

où $\overline{q}_\delta^p(\texttt{r, d, k})$ calcule le nombre de partitions de $r \in \mathcal{S}_\delta^p$ avec au plus d parts inférieures ou égales à k ∈ z*, avec $\overline{q}_\delta^p(\texttt{0, d, k}) = 1$ et $x_{n+1}$ = +∞. f(a) retourne la valeur maximale i ∈ z* de sorte que t(i) ≤ a, pour $\texttt{a} \in \mathcal{S}_\delta^p$ et t(i) = $\left\lceil \dfrac{i^p}{\delta} \right\rceil$.

Démonstration

Considérons un vecteur (leader en anglais) l = ($x_1$, $x_2$, ..., $x_n$) de dimension n et de norme $l_p$ $r_n = \sum_{i=1}^n x_i^p$ devant être indexé. Comme décrit précédemment, nous proposons d'utiliser le même principe que l'équation (4). Mais l'utilisation de la fonction $\overline{q}$ n'est plus possible, étant donné que les termes de somme d'une norme lp, avec p ≠ 1, ne sont pas toujours des entiers.

L'arrondi de $x_i^p$ à l'entier le plus proche avec une précision δ permet d'obtenir une norme entière $r_{\delta,n}^p$ à partir d'une somme de valeurs entières positives $\overline{x}_i$, comme défini dans l'équation (7). Par conséquent, le calcul de l'index d'un vecteur (leader en anglais) 1 situé sur une enveloppe de p ≠ 1 avec une précision δ peut être effectué en comptant le nombre de façons différentes d'écrire $r_{\delta,n}^p = \texttt{r}$ comme étant la somme de $\overline{x}_i \in \mathcal{S}_\delta^p$, où $\mathcal{S}_\delta^p$ est l'ensemble d'image de la fonction t définie par t: $\texttt{z}^* \rightarrow \mathcal{S}_\delta^p$ qui met en correspondance $x_i \rightarrow \overline{x}_i$ où $\texttt{t(x}_i\texttt{)} = \overline{x}_i = \left\lceil \dfrac{x_i^p}{\delta} \right\rceil$.

Il est ici important de noter que suivant les valeurs de p et δ la fonction t peut représenter une fonction non-injective, étant donné que différentes valeurs de z* peuvent être mises en correspondance avec la même valeur dans $\mathcal{S}_\delta^p$. En conséquence, différents vecteurs 1 ∈ $Z^{n*}$ peuvent avoir la même représentation dans $\mathcal{S}_\delta^{pn}$ et n'importe quelle procédure naïve pour compter le nombre de partitions dans $\mathcal{S}_\delta^{pn}$ conduirait non seulement à un index de vecteur (leader en anglais) erroné mais également à attribuer le même index erroné à des vecteurs distincts.

Nous définissons en tant que solution la fonction $\overline{q}_\delta^p(\texttt{r, d, k})$ comme étant la fonction qui compte le nombre de partitions de $r \in \mathcal{S}_\delta^p$ avec au plus d parts, où une part est donnée par $\texttt{t(i)} \in \mathcal{S}_\delta^p$, avec aucun

i supérieur à k, pour i, k $\in$ z*. Il doit être noté que la contrainte sur la valeur de la plus grande part dans $\mathcal{S}_\delta^p$ en utilisant indirectement une valeur k de z* permet de compter le nombre de vecteurs différents qui conduisent à une même partition dans $\mathcal{S}_\delta^{pn}$.

Par conséquent, en utilisant $\overline{q}_\delta^p(\text{r, d, k})$, l'équation (4) peut être étendue pour des normes lp par :

$$I_l = \sum_{\substack{j=0 \\ \text{tant que } x_{n-(j+1)} \neq 0}}^{n-2} \sum_{i=x_{n-j}+1}^{\min[x_{n-(j-1)}, f(r_{\delta,n-j}^p)]} \overline{q}_\delta^p(r_{\delta,n-j}^p - t(i), n-(j+1), i)$$

$$(9)$$

où f(a) retourne la valeur maximale i $\in$ z* de sorte que t(i) $\leq$ a, pour $a \in \mathcal{S}_\delta^p$.

En faisant varier j de 0 à n - 2 dans l'équation (9) nous comptons correctement le nombre de vecteurs précédant I pour les coordonnées $x_n$ à $x_2$. Dans le cas de la norme $l_1$, c'est une condition suffisante pour calculer le nombre total de vecteurs précédents, étant donné qu'il existe une seule valeur $x_1 \in$ z* pour laquelle $x_1 + \sum_{i=2}^n x_i = r_n$. Cependant, pour la norme $l_p$, il est possible que plusieurs valeurs $x_1 \in$ z* conduisent à $\overline{x}_1 + \sum_{i=2}^n \overline{x}_i = r_{\delta,n}^p$ en raison de la non-injection de la fonction t. Par conséquent, afin de garantir l'unicité de l'index, nous calculons le décalage entre min(f($\overline{x}_1$), $x_2$) et $x_1$ et ajoutons celui-ci au résultat de l'équation (9), pour obtenir l'index de vecteur (leader en anglais) décodable unique donné par l'équation (8) :

$$I_l = \sum_{\substack{j=0 \\ \text{tant que } x_{n-(j+1)} \neq 0}}^{n-2} \sum_{i=x_{n-j}+1}^{\min[x_{n-(j-1)}, f(r_{\delta,n-j}^p)]} \overline{q}_\delta^p(r_{\delta,n-j}^p - t(i), n-(j+1), i)$$
$$+ \min(f(\overline{x}_1), x_2) - x_1$$

La fonction min est requise étant donné que f($\overline{x}_1$) peut être supérieur à $x_2$ (voir l'exemple dans la section 4) alors que $x_1$ doit être plus petit ou égale à $x_2$.

Le calcul de $\overline{q}_\delta^p(\text{r, d, k})$ est fait à l'aide d'un algorithme de dénombrement.

3.3 Décodage d'un index de vecteur (leader en anglais)

Supposons que l'index $I_l$ du vecteur (leader en anglais) I = ($x_1$, $x_2$, ..., $x_n$) ainsi que l'index de sa norme lp $r_{\delta,n}^p$ sont transmis au décodeur. De plus, supposons que la dimension vectorielle n, le facteur de forme p ainsi que la précision δ utilisés dans l'étape de codage sont connus du côté du décodeur. L'objectif est ici d'extraire les valeurs correctes de $x_i$, $\forall i \in$ [1, n], en utilisant uniquement ces informations. Comme dans l'étape de codage, nous commençons par traiter la n$^{\text{ème}}$ coordonnée $x_n$.

Au niveau du décodeur, avec les informations concernant la norme et la dimension, il peut aisément être observé que $x_n \in [\text{imin}(r_{\delta,n}^p, \text{n}), f(r_{\delta,n}^p)]$ (voir les équations (8) et (10)). De plus, étant

donné que $l_I$ représente le nombre de vecteurs précédant **l**, le nombre de vecteurs avec la plus grande coordonnée $g_n$ $\geq$ $x_n$ est supérieur à $l_I$. Ceci signifie que $x_n$ est la première valeur de $i \in \{f(r^p_{\delta,n}),\ f(r^p_{\delta,n}) - 1,\ f(r^p_{\delta,n}) - 2,\ \ldots,\ \text{imin}(r^p_{\delta,n},\ n)\}$ pour laquelle le nombre de vecteurs avec la plus grande composante $g_n \geq i$ est plus grande que $l_I$.

Par conséquent, afin d'extraire $x_n$, nous comptons le nombre de vecteurs avec la plus grande composante variant de $f(r^p_{\delta,n})$ vers zéro jusqu'à l'obtention d'un nombre cumulé de vecteurs supérieur à $l_I$. En utilisant le principe introduit dans la section 3.1, ceci équivaut à calculer le nombre de partitions $N_p$ comme étant :

$$N_p = \sum_{\substack{i=f(r^p_{\delta,n}) \\ \text{tant que } N_p \leq l_I}}^{0} \overline{q}^p_\delta\left(r^p_{\delta,n} - t(i), n-1, i\right) \tag{11}$$

et attribuer à $x_n$ la première valeur de $i$ pour laquelle $N_p > l_I$. Dans l'étape suivante, nous décodons $x_{n-1}$.

En appliquant un principe identique à celui utilisé pour décoder $x_n$, nous observons que $x_{n-1} \in [\text{imin}(r^p_{\delta,n-1},\ n-1),\ \min[x_n,\ f(r^p_{\delta,n-1})]]$ (voir les équations (8) et (10)). Étant donné que $r^p_{\delta,n}$ est connu sur le décodeur et que $x_n$ a été décodé, $r^p_{\delta,n-1}$ peut être obtenu en calculant $r^p_{\delta,n-1} = r^p_{\delta,n} - t(x_n)$. Ensuite, pour décoder $x_{n-1}$, nous comptons $N_p$ en utilisant un mécanisme similaire à celui de l'équation (11), mais cette fois en ce qui concerne la (n-1)ème coordonnée.

Dans ce cas, étant donné que $N_p > l_I$, nous devons dans un premier temps pointer le compteur de partition $N_p$ de retour au premier vecteur (leader en anglais) avec la nème composante égale à $x_n$, en paramétrant $N_p$ à sa valeur précédente, qui est appelé ci-après $N_{pbckp}$ (la « valeur précédente » correspond à la valeur la plus forte de $N_p$ tel que $N_p \leq l_I$, c'est-à-dire, la valeur de $N_p$ avant que la dernière valeur de $i$ soit incluse dans la sommation). La valeur précédente désigne la plus grande valeur de $N_p$ pour laquelle $N_p \leq l_I$, c'est-à-dire, la valeur de $N_p$ avant d'inclure la dernière valeur de $i$ sur la somme. Par conséquent, nous attribuons à $x_{n-1}$ la première valeur de $i \in \{\min[x_n,\ f(r^p_{\delta,n-1})],\ \min[x_n,\ f(r^p_{\delta,n-1})] - 1,\ \ldots,\ \text{imin}(r^p_{\delta,n-1},\ n-1)\}$ pour laquelle le nombre de vecteurs avec la plus grande coordonnée $g_n = x_n$ et la deuxième plus grande coordonnée $g_{n-1} \geq i$ est supérieure à $l_I - N_{pbckp}$.

Ce processus peut être généralisé sur la dimension par :

$$N_p^{(j)} = N_{pbckp}^{(j-1)} + \sum_{\substack{i=\min[x_{n-(j-1)}, f(r^p_{\delta,n-j})] \\ \text{tant que } N_p^{(j)} \leq l_I}}^{0} \overline{q}^p_\delta\left(r^p_{\delta,n-j} - t(i), n-(j+1), i\right) \tag{12}$$

où $N_{pbckp}^{(j-1)} = 0$ pour $j = 0$, $\overline{q}^p_\delta(0,\ d,\ k) = 1$ et $x_{n+1} = +\infty$. En faisant varier $j$ de 0 à n - 2 nous pouvons décoder les coordonnées $x_n$ à $x_2$ du vecteur (leader en anglais) 1.

Une fois que la coordonnée $x_2$ est décodée, $r^p_{\delta,1}$ peut être obtenu en calculant $r^p_{\delta,1} = r^p_{\delta,2} - t(x_2)$. Cependant, comme décrit précédemment, plusieurs valeurs de $x_1 \in z^*$ peuvent être mises en correspondance dans $r^p_{\delta,1} \in \mathcal{S}^p_\delta$ (à partir de l'équation (7), il peut être déduit que $r^p_{\delta,1} = \overline{x}_1$). Pour obtenir la solution, nous introduisons le décalage $\min(f(r^p_{\delta,1}),\ x_2) - x_1$ sur le codeur de sorte que la coordonnée $x_1$ peut être décodée de manière unique en calculant $x_1 = \min(f(r_{\delta,1}^p),\ x_2) - (I_1 - N_{pbckp}^{(n-2)})$. En effet, il doit être noté

que $N_{pbckp}^{(n-2)}$ (la valeur précédente de $N_p$ obtenue après le décodage de $x_2$) est égal à la valeur calculée en utilisant l'équation (9) (la valeur de $I_l$ avant la sommation du décalage), étant donné que tous deux résultent de calculs strictement identiques.

Par conséquent, le vecteur (leader en anglais) $l = (x_1, x_2, ..., x_n)$ est décodé en utilisant uniquement les informations $I_l$, $r_{\delta,n}^p$, n, p et $\delta$. La section suivante décrit un exemple de codage et décodage de vecteur (leader en anglais).

4. Exemple de codage et décodage

Soit **v** = (-20, 16, 15, -40) un vecteur de réseau quantifié d'une source ayant une distribution Gaussienne généralisée de facteur de forme p = 0,3 devant être indexé. Étant donné que le calcul des indices de permutation et de signe n'est pas dans la portée de ces travaux, et peut être effectué aisément en utilisant [5, 13], nous nous focalisons ici sur l'indexage de vecteur (leader en anglais). Le vecteur (leader en anglais) correspondant au vecteur **v** est **l** = (15, 16, 20, 40). Les algorithmes de codage et décodage sont basés sur les principes suivants.

Étape de codage :

1) Initialisation : soit p = 0,3 et la précision $\delta$ = 0,1. Soit l'index de vecteur (leader en anglais) $I_l$ = 0 ;

$$r_{\delta,4}^p = \sum_{i=1}^{4}\left[\frac{x_i^{0.3}}{0.1}\right] = 10\,;$$

2) Calculer la norme lp du vecteur **l** avec une précision $\delta$ comme étant :

3) effectuer ces opérations, nous commençons par déterminer f(101). Dans ce cas, f(101) = 2264. Ensuite, en utilisant l'équation (8) pour j = 0 et i variant de 41 (c'est-à-dire, 40 + 1) à 2264 (c'est-à-dire, min(+∞, 2264)) conduit à :

$$I_l = 0 + \sum_{i=41}^{2264} \bar{q}_{0.1}^{0.3}\left(101 - \left[\frac{i^{0.3}}{0.1}\right], 3, i\right) = 10032\,;$$

4) Calculer le nombre de vecteurs précédant 1 mais avec la plus grande composante $g_4$ égale à 40. Ceci signifie

$$r_{\delta,3}^p = \sum_{i=1}^{3}\left[\frac{x_i^{0.3}}{0.1}\right] = 71$$

que nous devons sommer en 3 parts. L'utilisation des équations (8) avec f(71) = 704, j = 1 et i variant de 21 à 40 (c'est-à-dire, min(40, 704)) conduit à :

$$I_l = 10032 + \sum_{i=21}^{40} \bar{q}_{0.1}^{0.3}\left(71 - \left[\frac{i^{0.3}}{0.1}\right], 2, i\right) = 10076\,;$$

5) Calculer le nombre de vecteurs précédant 1 avec la plus grande composante $g_4$ = 40 et $g_3$ = 20. Dans ce cas,

$$r_{\delta,2}^p = \sum_{i=1}^{2}\left[\frac{x_i^{0.3}}{0.1}\right] = 46,$$

nous devons sommer en 2 parts. L'utilisation des équations (8) avec f(46) = 167, j = 2 et i variant de 17 à 20 (c'est-à-dire, min(20, 167)) conduit à :

$$I_l = 100765 + \sum_{i=17}^{20} \overline{q}_{0,1}^{0,3}\left(46 - \left[\frac{i^{0,3}}{0,1}\right], 1, i\right) = 10077;$$

6) Dans la dernière étape, mettre à jour $I_l$ en calculant (voir l'équation (8)).

$$I_l = 100774 + (\min(f(\overline{x}_1), x_2) - x_1)$$

$$= 100774 + (\min(f(23), 16) - 15)$$

$$= 100774 + (\min(17, 16) - 15)$$

$$= 100775.$$

Par conséquent, l'index du vecteur (leader en anglais) 1 = (15, 16, 20, 40) pour p = 0,3 et δ = 0,1 est $I_l$ = 100775. L'algorithme 1 dans l'annexe compile l'ensemble du processus de codage.

Étape de décodage :

1) Initialisation : soit $r_{\delta,n}^p = 101,$ 101, $I_l$ = 100775, p = 0,3, δ = 0, 1 et n = 4 ;

2) Calculer f(101) = 2264 ;

3) Décoder $x_4$. Dans ce cas, nous utilisons l'équation (12) avec j = 0 pour obtenir :

$$N_p^{(0)} = 0 + \sum_{\substack{i=\min[+\infty, 2264] \\ \text{tant que } N_p^{(0)} \leq I_l}}^{0} \overline{q}_{0,1}^{0,3}\left(101 - \left[\frac{i^{0,3}}{0,1}\right], 3, i\right).$$

En faisant varier i de 2264 à 41 nous obtenons $N_p^{(0)} = 100321 < 100775$. Cependant, en incluant i = 40 dans les résultats de sommation sur $N_p^{(0)} = 100321$ nous obtenons $N_p$ = 100786, qui est strictement supérieur à $I_l$. Étant donné que 100321 < 100775 < 100786, nous définissons la coordonnée $x_4$ à i = 40 et le vecteur (leader en anglais) obtenu est 1 = ($x_1$, $x_2$, $x_3$, 40). De plus, nous définissons $N_{pbckp}^{(0)} = 100321.$

$$r_{\delta,3}^p = 101 - \left[\frac{40^{0,3}}{0,1}\right] = 71,$$

4) Décoder $x_3$. Étant donné que $x_4$ = 40, nous avons $\qquad$ avec f(71) = 704. Ensuite, nous calculons $N_p^{(1)}$ :

$$N_p^{(1)} = 100321 + \sum_{\substack{i=\min[40, 704] \\ \text{tant que } N_p^{(1)} \leq I_l}}^{0} \overline{q}_{0,1}^{0,3}\left(71 - \left[\frac{i^{0,3}}{0,1}\right], 2, i\right)$$

Pour i = 21, nous obtenons $N_p^{(1)} = 100765 < 100775$ et pour i = 20,

$$N_p^{(1)} = 100777 > 100775.$$ Par conséquent, $x_3$ est défini à 20 et donc I = ($x_1$, $x_2$, 20, 40). Dans ce cas, $N_{pbckp}^{(1)} = 100765.$

$$r_{\delta,2}^p = 71 - \left\lceil \frac{20^{0,3}}{0,1} \right\rceil = 46,$$

5) Décoder $x_2$. Étant donné que $x_3$ = 20, nous avons     avec f(46) = 167.

Ensuite, nous calculons $N_p^{(2)}$ :

$$N_p^{(2)} = 100765 + \sum_{\substack{i=\min[20,167] \\ \text{tant que } N_p^{(2)} \le I_l}}^{0} \overline{q}_{0,1}^{0,3}\left(46 - \left\lceil \frac{i^{0,3}}{0,1} \right\rceil, 1, i\right).$$

$$r_{\delta,1}^p = 46 - \left\lceil \frac{16^{0,3}}{0,1} \right\rceil = 23.$$

Enfin, nous calculons $X_1$ : la dernière étape, décoder $x_1$. Étant donné que $x_2$ = 16, nous avons

$$\begin{aligned}
x_1 &= \min(f(r_{\delta,1}^p),\ x_2) - (I_l - N_{pbckp}^{(n-2)}) \\
&= \min(f(23),\ 16) - (100775 - 100774) \\
&= \min(17,\ 16) - (100775 - 100774) \\
&= 15.
\end{aligned}$$

Par conséquent, nous obtenons I = (15, 16, 20, 40). L'algorithme 2 dans l'annexe compile l'ensemble du processus de décodage.

5. Coût de mémoire et de calcul

5.1 Besoins de mémoire

Dans le cas où $\overline{q}_\delta^p(r,\ d,\ k)$ n'est pas calculé en ligne, les besoins de mémoire peuvent être calculés comme décrit ci-après.

Le $\overline{q}_\delta^p$ stocké, quelque soit l'algorithme de dénombrement utilisé, peut être interprété comme étant une table tridimensionnelle, où la première entrée est la valeur $r \in \mathcal{S}_\delta^p$, la deuxième est la dimension d $\in z^+$ et la troisième est la valeur de réseau maximale k $\in z^*$. Le besoin de mémoire maximal prévu est alors r·d·k·B octets, où B est le nombre d'octets par élément de $\overline{q}_\delta^p$.

Cependant, la limite pour les étapes de codage et de décodage effectives pour une norme maximale donnée $r_{\delta,n}^p = r$ et une dimension d est plus faible. En effet, à partir des équations (8), (10) et (12), il peut être observé que la plus grande valeur des deux premières variables d'entrée de $\overline{q}_\delta^p$ est obtenue lorsque j = 0 et i = imin(r, d). Dans ce cas, nous calculons $\overline{q}_\delta^p(r - t(imin(r,\ d),\ d - 1,\ imin(r,\ d)) =$

$$q_\delta^p \left( r - \left[ \frac{r}{d} \right], \quad d-1, \quad imin(r, \quad d) \right).$$

Par conséquent, il suffit d'utiliser la première variable d'entrée (liée à la norme) sur l'intervalle $\left[ 0, r - \left[ \frac{r}{d} \right] \right]$ et la deuxième (liée à la dimension) sur l'intervalle [1, d - 1].

La valeur de k peut être déterminée à partir de r. Étant donné que la deuxième contrainte n'est requise que si

$t(k) \leq \frac{r}{2}$, la valeur maximale de k peut être définie à k = $f\left( \frac{r}{2} \right)$ afin d'indexer un vecteur (leader en anglais) quelconque ayant une norme dans l'intervalle [0, r] et une dimension [1, d]. Par conséquent, la limite supérieure de coût de mémoire pour les étapes de codage et de décodage est donnée par :

$$\# M = \left( \left( r - \left[ \frac{r}{d} \right] \right) + 1 \right) \times (d - 1) \times \left( f\left( \left[ \frac{r}{2} \right] \right) + 1 \right) \cdot B \quad octets \qquad (13)$$

Il doit être noté que le besoin de mémoire dépend principalement de la norme et de la dimension des enveloppes. Le nombre de vecteurs détermine le choix de B.

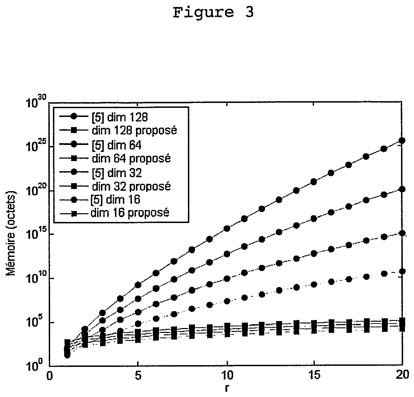

La figure 3 illustre l'économie de mémoire en utilisant l'algorithme d'indexage avec la table $\overline{q}_\delta^p$ calculée hors ligne. Le besoin de mémoire est représenté à partir de l'équation (13) en fonction du rayon r pour p = 1, δ = 1 et B = 4 (c'est-à-dire, des données de type entier) et est comparé à la limite supérieure de mémoire des méthodes classiques basées sur les vecteurs comme décrit dans [5]. Il doit être noté que même pour une dimension et un rayon aussi faible que 16 et 20, respectivement, les méthodes classiques ne requièrent pas plus de 10 gigaoctets de mémoire tandis que la méthode proposée nécessite moins de 100 kilo-octets.

Les besoins de mémoire extrêmement faibles et le fait qu'il n'est pas nécessaire de connaître tous les vecteurs permettent d'indexer les vecteurs de réseau dans des dimensions aussi élevées que 64, 128, 256, 512, etc. Dans les travaux antérieurs, les applications pratiques étaient limitées à une dimension de 16.

5.2 Coût de calcul

Le coût de calcul des algorithmes de codage/décodage d'index de vecteur (leader en anglais) est évalué dans cette section. Dans ce cas, nous négligeons le coût de construction de la table $\overline{q}_\delta^p(r, \quad d, \quad k)$ et des vecteurs f(i) et t(i), étant donné que celle-ci est effectuée hors ligne et une seule fois.

Le coût de calcul désigne le nombre d'opérations par vecteur (leader en anglais) de norme $r_{\delta,n}^p = r$ et de dimension d. À partir des équations (8) et des algorithmes (1) et (2) (voir l'annexe), il peut être déduit que les seules opérations requises sont des additions/soustractions (A) et des opérations logiques de comparaison (LC). Nous négligeons l'accès mémoire étant donné qu'il est beaucoup moins coûteux que ces deux types d'opérations.

Le coût de codage/décodage de l'algorithme d'indexage proposé est évalué ci-après. L'algorithme de décodage 2 est essentiellement l'inverse de l'algorithme de codage 1 et comporte approximativement le même nombre d'opérations. La complexité des algorithmes de codage et de décodage est évaluée en comptant le nombre d'opérations de l'algorithme 1 comme suit :

1) La somme cumulée met en oeuvre (n - 1)A

2) Le premier « for » (sur « j ») est effectué approximativement nnz(l) fois, en raison du test « if/break », où nnz(l) désigne le nombre de valeurs non-zéro de 1.

3) Pour chaque boucle du premier « for », nous avons :

    i. 1A et 7LC en raison du premier « if »

    ii. 1LC en raison de la fonction « min »

    iii. 3A et 1LC par boucle du « for » sur « i », qui se produit $min(x_{j+1}, \quad f(r_{\delta,j}^p)) - x_j$ fois

4) Avec le dernier « if » et la ligne suivante nous comptons 2A et 2LC

Par conséquent, le coût total des algorithmes de codage/décodage en termes d'additions, d'opérations logiques ou de comparaisons est donné par :

$$\#C = \left( (n+1) + nnz(\mathbf{l}) + 3 \cdot \sum_{j=n}^{\max} (\mathbf{min} - x_j) \right) A$$
$$+ \left( 2 + 8 \cdot nnz(\mathbf{l}) + \sum_{j=n}^{\max} (\mathbf{min} - x_j) \right) LC \qquad (14)$$

où nz(l) est le nombre d'éléments zéro du vecteur (leader en anglais) 1 et $\mathtt{min = min(x_{j+1}, \; f(r^p_{\delta,j}))}$ et
**max** = max(nz(l)+1,2).

Selon l'invention, l'indexage d'un vecteur de réseau est réduit à l'indexage de son vecteur (leader en anglais) correspondant et à des permutations et changements de signe. Nous proposons une solution pour indexer les vecteurs sans nécessiter aucune table de conversion ce qui permet de réduire l'utilisation de mémoire et la complexité de génération de tous les vecteurs (leader en anglais)s en anglais). De plus, cette solution fonctionne également pour des sources à distribution Gaussienne généralisée avec un paramètre de forme 0 < p ≤ 2. La méthode proposée est analytique et permet l'utilisation de dimensions vectorielles élevées.

ANNEXE

ALGORITHMES DE CODAGE ET DECODAGE

ALGORITHME 1

```
/* Algorithme de codage de l'indice de vecteur (leader en
anglais) appartenant à une surface de facteur de forme p
avec une précision δ et dimension n*/

CumTotal = cumsum(l, p, δ); //ᵃ
I₁ = 0;
maximum = +∞;
for(j=n-1;j>=1;j--) // Equivaut à la première sommation
      // de l'Equation (8)
{
      if(((p==1) && (l[j-1]==0)) || //ᵇ
 ((p!=1) && (l[j]==0)))
      break;
      else
      {
      r = CumTotal[j];
      for(i=min(maximum,f[r]);i>l[j];i--)
      {// Deuxième sommation de l'Equation (8)
      rmd = r-t[i];
      if(t[i]>rmd)// Pas de deuxième contrainte
      I₁ += q̄ᵖ_δ [rmd][j-1][0];
      else
      I₁ += q̄ᵖ_δ [rmd][j-1][i];
            }
      }
      maximum = l[j];
}
if(j==0)
      I₁ += min(f[CumTotal[0]],l[1]) - l[0];
return I₁;// La fonction termine ici

/*ᵃ La fonction cumsum(l, p, δ) calcule la somme cumulée du
vecteur (leader en anglais) l = (x₁, x₂, …, xₙ) dans le
domaine Sᵖ_δ et retourne un vecteur v = (t[x₁], t[x₁]+t[x₂],…,
t[x₁]+t[x₂]+…+t[xₙ]).
ᵇ Pour p = 1 on suppose que δ = 1.
Le tableau q̄ᵖ_δ [r][d][k] et les vecteurs f et t sont crées
offline par des algorithmes de dénombrement.*/
```

ALGORITHME 2

```
/* Algorithme de décodage pour un vecteur (leader en
anglais) l de appartenant à une surface de norme $r_{\delta,n}^p$ = r,
facteur de forme p et précision δ, dimension d = n et index
I₁ */


l = 0ₙ; // Vecteur de zéros de dimension n
maximum = +∞;
Nₚ = 0;
for(j=n-1;j>=1;j--) // Equivaut à varier j de 0 à n − 2
{                   // dans l'Equation (12)
        i = min(maximum,f[r]);
        while(Nₚ<=I₁)
        {
        N_pbckp = Nₚ;
        rmd = r - t[i];
        if(t[i]>rmd)// Pas de deuxième contrainte
        Nₚ += $\overline{q}_{\delta}^p$[rmd][j-1][0];
        else
        Nₚ += $\overline{q}_{\delta}^p$[rmd][j-1][i];
        i--;
        }
        i++;
        l[j] = i;
        Nₚ = N_pbckp;
        maximum = i;
        r -= t[i];
        if(r==0)
        break;
}
if(j==0)
        l[0] = min(f[r],l[1])-(I₁-Nₚ);
return l;// La fonction termine ici
```

**Revendications**

1. Procédé de traitement de données numériques comportant une étape de quantification consistant à calculer dans un espace de dimension d au moins un indice leader $l_l$ pour au moins une partie des vecteurs **l**, lesdits vecteurs **l** constituant des descripteurs de données d'entrées, le procédé étant **caractérisé en ce que** ledit indice leader $l_l$ correspond au nombre de vecteurs leaders qui précèdent ledit vecteur **l** dans l'ordre lexicographique inverse sans étape de détermination de la totalité des vecteurs leaders,
et **en ce que** l'étape de calcul de l'indice leader $l_l$ comprend une étape de calcul sélectionnée parmi le groupe consistant en :

- - une étape de calcul de la norme $r_{\delta,d}^p$ dudit vecteur $l(x_1, x_2, ..., x_d)$ où $x_1$ à $x_d$ sont ordonnés de manière croissante, et où la norme $r_d^p$ est définie telle que $r_d^p = \Sigma |x_i / \delta|$, i=1..d, et des étapes de dénombrement récursives sur les coordonnées $x_i$ avec i variant entre d et 1, lesdites étapes de dénombrement consistant à dénombrer les vecteurs dont la coordonnée $x_i$ est comprise entre $x_i+1$ et $MIN(x_{i+1}, \ F(r_{\delta,i}^p))$, l'indice $l_l$ étant égal à la somme des résultats des étapes de dénombrement plus la différence entre $\min(F(T(x_1)), x_2)$

et $x_1$, , la fonction $T(x_i)$ retournant le résultat de la division de la coordonnée $x_i$ élevé à la puissance p par un facteur de précision delta, le résultat de ladite division étant arrondi à l'entier le plus proche, et F(A) étant une fonction qui retourne une valeur entière w dont la valeur T(w) est plus petite ou égale à l'argument A de ladite fonction F ;

- - une étape de calcul de la norme $r_{\delta,d}^{p}$ dudit vecteur $l(x_1, x_2, ..., x_d)$ où $x_1$ à $x_d$ sont ordonnés de manière décroissante, et des étapes de dénombrement récursives sur les coordonnées $x_i$ avec i variant entre 1 et d, lesdites étapes de dénombrement consistant à dénombrer les vecteurs dont la coordonnée $x_i$ est comprise entre $x_i$+1 et $\mathrm{MIN}(x_{i-1}, F(r_{\delta,i}^{p}))$, l'indice $I_l$ étant égal à la somme des résultats des étapes de dénombrement plus la différence entre min(F(T($x_d$)), $x_{d-1}$) et $x_d$, , la fonction $T(x_i)$ retournant le résultat de la division de la coordonnée $x_i$ élevé à la puissance p par un facteur de précision delta, le résultat de ladite division étant arrondi à l'entier le plus proche, et F(A) étant une fonction qui retourne une valeur entière w dont la valeur T(w) est plus petite ou égale à l'argument A de ladite fonction F.

2. Procédé de traitement selon la revendication précédente, **caractérisé en ce qu'**il ne comporte aucune étape de détermination de vecteurs autre que le vecteur **I** en cours de calcul.

3. Application de l'un quelconque des procédés objet des revendications 1 à 2, pour la compression de données vectorielles consistant à enregistrer le résultat du codage binaire dudit index $I_l$ ainsi qu'au moins un indice de signe $I_s$, un indice de norme $I_n$ et un indice de permutation $I_p$.

4. Application de compression selon la revendication 3, **caractérisée en ce que** lesdites données vectorielles sont choisies parmi les éléments suivants :

   - des images numériques ;
   - des séquences vidéo numériques ;
   - des données audio numériques ;
   - des objets tridimensionnels numériques ;
   - des objets tridimensionnels animés numériques ;
   - des coefficients issus d'une transformation, ou
   - des informations enregistrées dans une base de données.

5. Application de l'un quelconque des procédés objet des revendications 1 à 2, pour la recherche dans une base de données vectorielle consistant à calculer pour une information de référence un index $I_{l,ref}$ ainsi qu'au moins un indice de signe $I_{s,ref}$, un indice de norme $I_{n,ref}$ et un indice de permutation $I_{p,ref}$ et à rechercher les données associées aux mêmes indices.

6. Application de recherche selon la revendication 5, **caractérisée en ce que** les données vectorielles sont choisies parmi les éléments suivants :

   - des images numériques ;
   - des séquences vidéo numériques ;
   - des données audio numériques ;
   - des objets tridimensionnels numériques ;
   - des objets tridimensionnels animés numériques ;
   - des coefficients issus d'une transformation, ou
   - des objets d'une base de données textuelles.

7. Procédé de reconstruction d'une donnée numérique à partir de l'indice leader $I_l$ calculé selon un procédé conforme à l'une au moins des revendications 1 à 2 **caractérisé en ce que** l'on calcule les coordonnées $(x_1, x_2, ..., x_d)$ d'un vecteur leader **I** et **en ce que** l'on applique à un indice $I_l$ un traitement consistant à rechercher le vecteur leader **I** dont l'indice $I_l$ correspond au même nombre de vecteurs précédents ledit vecteur **I** dans l'ordre lexicographique inverse sans étape de détermination de la totalité des vecteurs.

8. Procédé de reconstruction d'une donnée numérique selon la revendication 7, **caractérisé en ce que** l'on procède à un traitement récursif sur la variable i variant entre d et 1, ledit traitement étant appliqué sur la coordonnée $x_i$ avec

$x_i$ variant de $MIN(x_{i+1}, F(r_{\delta,i}^{p}))$ à 0 et consistant à sommer les résultats des étapes de dénombrement par application de ladite fonction F(A), jusqu'à ce que ladite somme soit supérieure audit indice $l_l$, la coordonnée recherchée $x_i$ étant celle conduisant au dépassement dudit indice $l_l$, le procédé consistant ensuite à poursuivre, pour la coordonnée $x_{i-1}$, la sommation à partir de la valeur $l_{l'}$ où $l_{l'}$ est la valeur précédent la valeur $l_l$ avant ledit dépassement.

9. Procédé de reconstruction d'une donnée numérique selon la revendication 7, **caractérisé en ce que** l'on procède à un traitement récursif sur la variable i variant entre 1 et d, ledit traitement étant appliqué sur la coordonnée $x_i$ avec $x_i$ compris entre $MIN(x_{i-1}, F(r_{\delta,i}^{p}))$ et 0 et consistant à sommer les résultats des étapes de dénombrement par application de ladite fonction F(A), jusqu'à ce que ladite somme soit supérieure audit indice $l_l$, la coordonnée recherchée $x_i$ étant celle conduisant au dépassement dudit indice $l_l$, le procédé consistant ensuite à poursuivre, pour la coordonnée $x_{i+1}$, la sommation à partir de la valeur $l_{l'}$ où $l_{l'}$ est la valeur précédent la valeur $l_l$ avant ledit dépassement.

**Patentansprüche**

1. Verfahren zum Verarbeiten von digitalen Daten, umfassend einen Quantifizierungsschritt, der darin besteht, in einem Raum der Dimension d mindestens einen Leitindex $l_l$ für mindestens einen Teil der Vektoren 1 zu berechnen, wobei die Vektoren 1 Deskriptoren von Eingangsdaten darstellen, wobei das Verfahren **dadurch gekennzeichnet ist, dass** der Leitindex $l_l$ der Anzahl an Leitvektoren entspricht, die dem Vektor 1 in der umgekehrten lexikografischen Ordnung vorangehen, ohne Schritt des Bestimmens der Gesamtheit der Leitvektoren, und dadurch, dass der Schritt des Berechnens des Leitindex $l_l$ einen Berechnungsschritt umfasst, ausgewählt aus der Gruppe bestehend aus:

-- einem Schritt des Berechnens der Norm $r_{\delta,d}^{p}$ des Vektors $l(x_1, x_2, ..., x_d)$, worin $x_1$ bis $x_d$ in aufsteigender Weise geordnet sind, und worin die Norm $r_{\delta,d}^{p}$ so definiert ist, dass $r_{\delta,d}^{p} = \sum |x_i / \delta|$, i = 1..d, und von rekursiven Zählschritten an den Koordinaten $x_i$, wobei i zwischen d und 1 variiert, wobei die Zählschritte im Zählen der Vektoren bestehen, deren Koordinate $x_i$ zwischen $x_i+1$ und $MIN(x_{i+1}, F(r_{\delta,i}^{p}))$ umfasst ist, wobei der Index $l_l$ gleich der Summe der Ergebnisse der Zählschritte plus der Differenz zwischen $min(F(T(x_1)),x_2)$ und $x_1$ ist, wobei die Funktion $T(x_i)$ das Ergebnis der Division der mit dem Exponenten p potenzierten Koordinate $x_i$ durch einen Genauigkeitsfaktor Delta zurückgibt, wobei das Ergebnis der Division auf die nächste ganze Zahl gerundet wird, und wobei F(A) eine Funktion ist, die einen ganzzahligen Wert w zurückgibt, dessen Wert T(w) kleiner oder gleich dem Argument A der Funktion F ist;

-- einem Schritt des Berechnens der Norm $r_{\delta,d}^{p}$ des Vektors $l(x_1, x_2, ..., x_d)$, worin $x_1$ bis $x_d$ in absteigender Weise geordnet sind, und von rekursiven Zählschritten an den Koordinaten $x_i$, wobei i zwischen 1 und d variiert, wobei die Zählschritte im Zählen der Vektoren bestehen, deren Koordinate $x_i$ zwischen $x_i+1$ und $MIN(x_{i-1}, F(r_{\delta,i}^{p}))$ umfasst ist, wobei der Index $l_l$ gleich der Summe der Ergebnisse der Zählschritte plus der Differenz zwischen $min(F(T(x_d)),x_{d-1})$ und $x_d$ ist, wobei die Funktion $T(x_i)$ das Ergebnis der Division der mit dem Exponenten p potenzierten Koordinate $x_i$ durch einen Genauigkeitsfaktor Delta zurückgibt, wobei das Ergebnis der Division auf die nächste ganze Zahl gerundet wird, und wobei F(A) eine Funktion ist, die einen ganzzahligen Wert w zurückgibt, dessen Wert T(w) kleiner oder gleich dem Argument A der Funktion F ist.

2. Verarbeitungsverfahren nach dem vorstehenden Anspruch, **dadurch gekennzeichnet, dass** es keinen Schritt des Bestimmens von anderen Vektoren als dem Vektor l im Laufe der Berechnung umfasst.

3. Anwendung eines der Verfahren, die Gegenstand der Ansprüche 1 bis 2 sind, für das Komprimieren von Vektordaten, bestehend im Speichern des Ergebnisses der Binärcodierung des Index $l_l$, sowie mindestens eines Vorzeichenindex

I$_s$, eines Normindex In und eines Permutationsindex I$_p$.

4. Komprimieranwendung nach Anspruch 3, **dadurch gekennzeichnet, dass** die Vektordaten aus den folgenden Elementen ausgewählt sind:

- digitalen Bildern;
- digitalen Videosequenzen;
- digitalen Audiodaten;
- digitalen dreidimensionalen Gegenständen;
- animierten digitalen dreidimensionalen Gegenständen;
- aus einer Transformation stammenden Koeffizienten, oder
- in einer Datenbank gespeicherten Informationen.

5. Anwendung eines der Verfahren, die Gegenstand der Ansprüche 1 bis 2 sind, für die Suche in einer Vektordatenbank, bestehend im Berechnen, für eine Referenzinformation, eines Index I$_{l,ref}$, sowie mindestens eines Vorzeichenindex I$_{s,ref}$, eines Normindex I$_{n,ref}$ und eines Permutationsindex I$_{p,ref}$, und im Suchen der den gleichen Indizes zugeordneten Daten.

6. Suchanwendung nach Anspruch 5, **dadurch gekennzeichnet, dass** die Vektordaten aus den folgenden Elementen ausgewählt sind:

- digitalen Bildern;
- digitalen Videosequenzen;
- digitalen Audiodaten;
- digitalen dreidimensionalen Gegenständen;
- animierten digitalen dreidimensionalen Gegenständen;
- aus einer Transformation stammenden Koeffizienten, oder
- Gegenständen einer Textdatenbank.

7. Verfahren zum Rekonstruieren einer digitalen Dateneinheit ausgehend vom Leitindex I$_l$, der nach einem Verfahren gemäß mindestens einem der Ansprüche 1 bis 2 berechnet wurde, **dadurch gekennzeichnet, dass** die Koordinaten $(x_1, x_2, ..., x_d)$ eines Leitvektors I berechnet werden und dadurch, dass auf einen Index I$_l$ eine Verarbeitung angewendet wird, die im Suchen des Leitvektors I besteht, dessen Index I$_l$ der gleichen Anzahl an Vektoren entspricht, die dem Vektor I in der umgekehrten lexikografischen Ordnung vorangehen, ohne Schritt des Bestimmens der Gesamtheit der Vektoren.

8. Verfahren zum Rekonstruieren einer digitalen Dateneinheit nach Anspruch 7, **dadurch gekennzeichnet, dass** eine rekursive Verarbeitung an der Variable i vorgenommen wird, die zwischen d und I variiert, wobei die Verarbeitung auf die Koordinate $x_i$ angewendet wird, wobei $x_i$ von $\mathrm{MIN}(x_{i+1},\ \mathbf{F}(r_{\delta,i}^{P}))$ bis 0 variiert, und im Summieren der Ergebnisse der Zählschritte durch Anwenden der Funktion F(A) besteht, bis die Summe größer ist als der Index I$_l$, wobei die gesuchte Koordinate $x_i$ diejenige ist, die zum Überschreiten des Index I$_l$ führt, wobei das Verfahren anschließend darin besteht, für die Koordinate $x_{i-1}$ das Summieren ausgehend vom Wert I$_l'$ weiterzuführen, worin I$_l'$ der Wert ist, der dem Wert I$_l$ vor der Überschreitung vorangeht.

9. Verfahren zum Rekonstruieren einer digitalen Dateneinheit nach Anspruch 7, **dadurch gekennzeichnet, dass** eine rekursive Verarbeitung an der Variable i vorgenommen wird, die zwischen I und d variiert, wobei die Verarbeitung auf die Koordinate $x_i$ angewendet wird, wobei $x_i$ zwischen $\mathrm{MIN}(x_{i-1},\ \mathbf{F}(r_{\delta,i}^{P}))$ und 0 umfasst ist, und im Summieren der Ergebnisse der Zählschritte durch Anwenden der Funktion F(A) besteht, bis die Summe größer ist als der Index I$_l$, wobei die gesuchte Koordinate $x_i$ diejenige ist, die zum Überschreiten des Index I$_l$ führt, wobei das Verfahren anschließend darin besteht, für die Koordinate $x_{i+1}$ das Summieren ausgehend vom Wert I$_l'$ weiterzuführen, worin I$_l'$ der Wert ist, der dem Wert I$_l$ vor der Überschreitung vorangeht.

**Claims**

1. Method for processing digital data comprising a quantisation step which consists in calculating in a dimension space d at least one leader index $I_l$ for at least one part of the vectors l, the said vectors l constituting descriptors of input data, the method being **characterised in that** the said leader index $I_1$ corresponds to the number of vectors that precede the said leader l in reverse lexicographical order without the step of determining all the leaders, and that the step of calculating the leader index $I_1$ comprises one step of calculating selected from the group consisting of:

    - step of calculating the norm $r_{\delta,d}^{p}$ of the said leader $l(x_1, x_2, ...x_d)$, where $x_1$ to $x_d$ are sorted in increasing order, where the norm $r_{\delta,d}^{p}$ is defined as $r_{\delta,d}^{p} = \sum |x_1 / \delta|$, i=1..d, and recursive counting steps on the coordinates $x_i$ with the value of i ranging from d to 1, the said counting steps consisting in counting the vectors in which the coordinate $x_i$ is comprised between $x_{i+1}$ and $MIN(x_{i+1}, F(r_{\delta,i}^{p}))$, the index $I_l$ being equal to the sum of the results of the counting steps adding the difference between $\min(F(T(x_1)) x_2)$ and $x_l$, the function $T(x_i)$ returning the result of dividing the coordinate $x_i$ raised to the power p by a precision factor delta, the result of the said division being rounded to the nearest integer, and F(A) being a function that returns an integer value w in which the value T (w) is lower than or equal to the argument A of the said function F;

    - step of calculating the norm $r_{\delta,d}^{p}$ of the said leader $l(x_1, x_2, ...x_d)$, where $x_1$ to $x_d$ are sorted in decreasing order, and recursive counting steps on the coordinates $x_i$ with the value of i ranging from 1 to d, the said counting steps consisting in counting the vectors in which the coordinate $x_i$ is comprised between $x_{i+1}$ and

    $MIN(x_{i-1}, F(r_{\delta,i}^{p}))$, the index $I_l$ being equal to the sum of the results of the counting steps adding the difference between $\min(F(T(x_d)) x_{d-1})$ and $x_d$, the function $T(x_i)$ returning the result of dividing the coordinate $x_i$ raised to the power p by a precision factor delta, the result of the said division being rounded to the nearest integer, and F(A) being a function that returns an integer value w in which the value T (w) is lower than or equal to the argument A of the said function F.

2. Processing method according to the preceding claim, **characterised in that** it does not include any steps of determining vectors other than the leader 1 currently being calculated.

3. Application of any one of the methods of claims 1 to 2, for the compression of vector data consisting in recording the result of binary coding of the said index $I_l$ as well as at least a sign index $I_s$, a norm index $I_n$ and a permutation index $I_p$.

4. Compression application according to claim 3, **characterised in that** the said vector data are selected from the group consisting of:

    - digital images;
    - digital video sequences;
    - digital audio data;
    - digital three-dimensional objects;
    - digital animated three-dimensional objects;
    - coefficients from a transformation, or
    - information stored in a database.

5. Application of any one of the methods of claims 1 to 2, for searching in a vector database consisting in calculating for reference information an index $I_{l,ref}$ as well as at least one sign index $I_{s,ref}$, a norm index $I_{n,ref}$ and a permutation index $I_{p,ref}$ and in searching for the data associated with the same indices.

6. Search application according to claim 5, **characterised in that** the said vector data are selected from the group consisting of:

- digital images;
- digital video sequences;
- digital audio data;
- digital three-dimensional objects;
- digital animated three-dimensional objects;
- coefficients from a transformation or
- objects in a text database.

7. Method for reconstructing a digital datum according to the leader index $l_l$ calculated using a method according to at least one of the claims from 1 to 2 **characterized in that** it comprises calculating the coordinates ($x_l$, $x_2$, $x_d$) of a leader 1 and that it comprises applying to an index $l_l$ a treatment which involves finding the leader 1 with the index $l_l$ which corresponds to the same number of vectors preceding the said leader 1 in reverse lexicographical order without a step of determining all the leaders.

8. Method for reconstructing a digital datum according to claim 7, **characterised in that** a recursive treatment is performed on the variable i ranging from d to 1, the said treatment being applied to the coordinate $x_i$ with $x_i$ ranging from $\mathrm{MIN}(x_{i+1}, \quad F(r_{\delta,i}^{P}))$ $\mathrm{MIN}(x_{i+1}$, to 0 and consisting in adding the results of the counting steps by means of applying the said function F(A), until the said sum is greater than the said index $l_l$, the sought coordinate $x_i$ being that which leads to the said index $l_l$ being surpassed, the method then consisting in continuing, for the coordinate $X_{i-1}$, the sum from the value $l_{l'}$, in which $l_{l'}$ is the value preceding the value $l_{l'}$ prior to surpassing the said index.

9. Method for reconstructing a digital datum according to claim 7, **characterised in that** a recursive treatment is performed on the variable i ranging from 1 to d, the said treatment being applied to the coordinate $x_i$ with $x_i$ ranging from $\mathrm{MIN}(x_{i-1}, \quad F(r_{\delta,i}^{P}))$ to 0 and consisting in adding the results of the counting steps by means of applying the said function F(A), until the said sum is greater than the said index $l_l$, the sought coordinate $x_i$ being that which leads to the said index $l_1$ being surpassed, the method then consisting in continuing, for the coordinate $X_{i+1}$, the sum from the value $l_{l'}$, in which $l_{l'}$ is the value preceding the value $l_l$ prior to surpassing the said index.

Figure 1

Figure 2

Figure 3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• WO 9933185 A

**Littérature non-brevet citée dans la description**

• **P. LOYER et al.** Lattice Codebook Enumeration for Generalised Gaussian Source. *IEEE Transactions on Information Theory,* 2003, vol. 49 (2